(19) Europäisches Patentamt
European Patent Office
Office européen des brevets

(11) EP 2 277 057 B1

(12) **FASCICULE DE BREVET EUROPEEN**

(45) Date de publication et mention de la délivrance du brevet:
**28.03.2018 Bulletin 2018/13**

(21) Numéro de dépôt: **09745773.3**

(22) Date de dépôt: **14.05.2009**

(51) Int Cl.:
*G01R 33/02* (2006.01)        *G01R 33/025* (2006.01)
*G01C 17/38* (2006.01)

(86) Numéro de dépôt international:
**PCT/EP2009/055803**

(87) Numéro de publication internationale:
**WO 2009/138441 (19.11.2009 Gazette 2009/47)**

(54) **PROCÉDÉ DE MESURE DE CHAMP MAGNÉTIQUE PAR UN CAPTEUR TRIAXIAL**

VERFAHREN ZUR MESSUNG EINES MAGNETFELDS MIT EINEM DREIACHSIGEN SENSOR

METHOD OF MEASURING A MAGNETIC FIELD BY A THREE-AXIS SENSOR

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **14.05.2008 FR 0802605**

(43) Date de publication de la demande:
**26.01.2011 Bulletin 2011/04**

(73) Titulaires:
• **Movea**
**38000 Grenoble (FR)**
• **Commissariat à l'Énergie Atomique et aux Énergies Alternatives**
**75015 Paris (FR)**

(72) Inventeurs:
• **GRENET, Pierre**
**F-38000 Grenoble (FR)**
• **EL-MARFOUQ, Ismael**
**F-38046 Saint Martin D'heres (FR)**

• **CATTIN, Viviane**
**F-38120 Saint Egreve (FR)**

(74) Mandataire: **Brunelli, Gérald**
**Marks & Clerk France**
**Immeuble Visium**
**22, avenue Aristide Briand**
**94117 Arcueil Cedex (FR)**

(56) Documents cités:
| | |
|---|---|
| **EP-A- 0 041 892** | **EP-A- 0 226 653** |
| **EP-A- 0 436 794** | **EP-A- 0 718 598** |
| **WO-A-02/46693** | **WO-A-92/16719** |
| **FR-A- 2 663 428** | **FR-A- 2 704 065** |
| **FR-A- 2 766 935** | **US-A- 5 134 369** |
| **US-A- 5 182 514** | **US-A- 6 122 538** |
| **US-A- 6 130 534** | **US-A1- 2002 188 416** |
| **US-A1- 2003 149 528** | **US-A1- 2005 173 153** |
| **US-B1- 7 216 055** | |

EP 2 277 057 B1

**Description**

L'invention porte sur un procédé de mesure de champ magnétique triaxial par un capteur principal triaxial de mesure de champ magnétique mobile conjointement avec un élément porteur capable de générer au moins un champ magnétique additionnel perturbant les mesures dudit capteur. Un capteur de mesure de champ magnétique peut être associé à un élément porteur pouvant provoquer des perturbations magnétiques, par exemple une voiture ou un téléphone portable.

Il est connu de tenter de placer le capteur de sorte que les perturbations magnétiques engendrées par l'élément porteur soient minimales. Il est également connu de disposer des aimants ou autres objets ferromagnétiques de manière à tenter de compenser les perturbations magnétiques.

Ces méthodes sont peu fiables, peu précises, et ne tiennent pas compte de modifications des perturbations ferromagnétiques engendrées par l'élément porteur.

Dans le cas d'un capteur scalaire, i.e. délivrant uniquement une norme de champ magnétique, des procédés de compensation des perturbations ont été décrites par exemple à l'adresse URL http://www.rmsinst.com/aero%20compensation.htm, à laquelle sont décrits des systèmes d'enregistrement de données de la société RMS Instruments. De tels systèmes utilisent de manière continue un capteur additionnel scalaire de référence pour les mesures.

Cet enseignement ne peut s'appliquer à un capteur triaxial de mesure de champ magnétique.

Les documents US-A-5,182,514 et WO-A-02/46693 divulguent un procédé de mesure de champ magnétique triaxial par un capteur principal triaxial. La présente invention vise à résoudre les problèmes mentionnés précédemment. La présente invention comporte un procédé tel que décrit dans la revendication 1.

Selon un aspect il est proposé un système de mesure de champ magnétique comprenant un capteur principal triaxial de mesure de champ magnétique mobile conjointement avec un élément porteur capable de générer au moins un champ magnétique additionnel perturbant les mesures dudit capteur. Ledit capteur principal triaxial est adapté pour fournir des mesures orthonormées pour un champ magnétique de référence en l'absence de perturbations magnétiques dues audit élément porteur. Le système comprend des moyens de réglage dudit capteur principal triaxial comprenant des moyens de détermination du champ magnétique de référence.. Ainsi, on permet de régler ou calibrer le capteur triaxial de mesure du champ magnétique, de manière à ce qu'en utilisation courante, il tienne compte des perturbations magnétiques engendrées par l'élément porteur.

Selon un mode de réalisation, lesdits moyens de réglage dudit capteur principal triaxial comprennent des moyens de détermination du ou des champs magnétiques additionnels générés par ledit élément porteur à partir de paramètres comprenant des coefficients représentatifs de la sensibilité magnétique dudit élément porteur, des mesures effectuées par ledit capteur principal triaxial, et des variations temporelles de ces dites mesures.

On peut ainsi déterminer simplement, avec précision et à faible coût, le ou les champs magnétiques additionnels générés par ledit élément porteur.

Dans un mode de réalisation, lesdits moyens de détermination du ou des champs magnétiques additionnels générés par ledit élément porteur sont adaptés pour mettre en oeuvre le système d'équations suivant :

$$\begin{cases} B_{réel_x} = B_{mesuré_x} - \left( B_{rémanent_x} + A \times V_x \right) \\ B_{réel_y} = B_{mesuré_y} - \left( B_{rémanent_y} + A \times V_y \right) \\ B_{réel_z} = B_{mesuré_z} - \left( B_{rémanent_z} + A \times V_z \right) \end{cases}$$

dans lequel:

$B_{réel_x}$, $B_{réel_y}$, et $B_{réel_z}$ représentent les composantes respectives du champ magnétique réel selon les trois axes du capteur principal triaxial ;

$B_{mesuré_x}$, $B_{mesuré_y}$, et $B_{mesuré_z}$ représentent les composantes respectives du champ magnétique mesuré par le capteur principal triaxial selon ses trois axes;

$B_{rémanent_x}$, $B_{rémanent_y}$, et $B_{rémanent_z}$ représentent les composantes respectives du champ magnétique rémanent selon les trois axes du capteur principal triaxial ;

$$A = \left[ B_{mesuré_x} ; B_{mesuré_y} ; B_{mesuré_z} ; \frac{\partial B_{mesuré_x}}{\partial t} ; \frac{\partial B_{mesuré_y}}{\partial t} ; \frac{\partial B_{mesuré_z}}{\partial t} \right] ;$$

et

les vecteurs $V_x$, $V_y$ et $V_z$ ont pour composantes les coefficients représentatifs de la sensibilité magnétique dudit élément porteur :

$$V_x = \begin{bmatrix} a_{xx}^i \\ a_{yx}^i \\ a_{zx}^i \\ a_{xx}^f \\ a_{yx}^f \\ a_{zx}^f \end{bmatrix} \quad V_y = \begin{bmatrix} a_{xy}^i \\ a_{yy}^i \\ a_{zy}^i \\ a_{xy}^f \\ a_{yy}^f \\ a_{zy}^f \end{bmatrix} \quad V_z = \begin{bmatrix} a_{xz}^i \\ a_{yz}^i \\ a_{zz}^i \\ a_{xz}^f \\ a_{yz}^f \\ a_{zz}^f \end{bmatrix}$$

dont les composantes ou coefficients représentatifs de la sensibilité magnétique dudit élément porteur $a_{jk}^i$ représentent respectivement le coefficient de proportionnalité entre la valeur de la perturbation sur l'axe j due à l'axe k et la valeur du champ sur l'axe k, pour le champ magnétique induit, et les composantes ou coefficients représentatifs de la sensibilité magnétique dudit élément porteur $a_{jk}^f$ représentent respectivement le coefficient de proportionnalité entre la valeur de la perturbation sur l'axe j due à l'axe k et la valeur de la dérivée temporelle du champ sur l'axe k, pour le champ magnétique du aux courants de Foucault.

On détermine ainsi avec précision et peu de calculs le champ magnétique réel, sans tenir compte des perturbations magnétiques engendrées par 'élément porteur et mesurées par le capteur principal triaxial.

Selon un mode de réalisation, lesdits moyens de détermination du champ magnétique de référence comprennent un générateur de champ magnétique prédéterminé.

Il est ainsi possible de connaître aisément le champ magnétique de référence auquel est soumis le système.

Dans un mode de réalisation, lesdits moyens de détermination du champ magnétique de référence comprennent un capteur additionnel amovible de mesure de champ magnétique, mobile conjointement avec ledit élément porteur, et disposé à l'extérieur dudit élément porteur en dehors du ou des champs magnétiques additionnels.

Il est ainsi possible de connaître aisément et à coût réduit le champ magnétique de référence auquel est soumis le système.

Par exemple, ledit capteur additionnel amovible de mesure de champ magnétique est un capteur additionnel triaxial, dont les axes sont respectivement parallèles aux axes du capteur principal triaxial.

L'utilisation d'un tel capteur permet d'obtenir une précision améliorée.

Par exemple, ledit capteur additionnel amovible de mesure de champ magnétique est un capteur scalaire.

Ce mode de réalisation est moins coûteux et plus simple à réaliser.

Dans le cas d'un capteur additionnel triaxial, lesdits moyens de réglage dudit capteur principal triaxial peuvent comprendre des premiers moyens de calcul adaptés pour calculer les composantes respectives du champ magnétique rémanent par différences entre des moyennes de mesures effectuées simultanément par les deux capteurs triaxiaux.

Un tel calcul est simple à réaliser.

Par exemple, lesdits moyens de réglage dudit capteur principal triaxial comprennent des deuxièmes moyens de calcul des vecteurs desdits coefficients représentatifs de la sensibilité magnétique dudit élément porteur par estimation des moindres carrés sur le système d'équations suivant :

$$\begin{cases} A \times V_x = \left( B_{mesuré_x} - B_{rémanent_x} \right) \\ A \times V_y = \left( B_{mesuré_y} - B_{rémanent_y} \right) . \\ A \times V_z = \left( B_{mesuré_z} - B_{rémanent_z} \right) \end{cases}$$

L'invention fournit un résultat de précision améliorée.

En variante, avec un capteur additionnel amovible scalaire, lesdits moyens de réglage dudit capteur principal triaxial comprennent des moyens d'optimisation adaptés pour optimiser l'égalité suivante pour une série de mesures effectuées simultanément avec ledit capteur principal triaxial et ledit capteur scalaire :

$$\left\| Mes\_scalaire \right\| = \left\| B_{mesuré} - B_{perturbateur} \right\|$$

dans laquelle $\|Mes\_scalaire\|$ représente une norme d'une mesure du capteur scalaire, et $B_{perturbateur}$ représente le champ magnétique additionnel perturbant généré par ledit élément porteur tel que décrit précédemment pour les moyens de détermination du ou des champs magnétiques additionnels générés par ledit élément porteur.

Les calculs sont simplifiés. Si en outre, un réglage préalable a été fait tel que décrit précédemment avec un capteur additionnel triaxial, on peut en déduire des composantes négligeables permettant de simplifier encore les calculs à effectuer.

Dans un mode de réalisation, le système comprend, en outre, des moyens de correction des mesures dudit capteur principal triaxial adaptés pour délivrer le champ magnétique réel à partir du champ magnétique mesuré par le capteur principal triaxial et des données fournies par lesdits moyens de réglage en utilisant le système d'équations suivant :

$$\begin{cases} B_{réel_x} = B_{mesuré_x} - \left( B_{rémanent_x} + A \times V_x \right) \\ B_{réel_y} = B_{mesuré_y} - \left( B_{rémanent_y} + A \times V_y \right) \\ B_{réel_z} = B_{mesuré_z} - \left( B_{rémanent_z} + A \times V_z \right) \end{cases}$$

Selon un mode de réalisation, le système comprend, en outre, des moyens de correction prédictive par prise en compte des perturbations d'un modèle prédictif, par descente de gradient du ou des champs magnétiques additionnels adaptés pour utiliser la relation suivante :

$$B_{mesuré} = (I + [V_x(1 \to 3) \quad V_y(1 \to 3) \quad V_z(1 \to 3)]) * Rot * B_0$$
$$+ [V_x(1 \to 3) \quad V_y(1 \to 3) \quad V_z(1 \to 3)] * \frac{\partial}{\partial t}(Rot * B_0)$$

dans laquelle:

I représente la matrice identité $\begin{pmatrix} 1 & 0 & 0 \\ 0 & 1 & 0 \\ 0 & 0 & 1 \end{pmatrix}$ ; $B_0$ représente le champ magnétique de référence ;

$V_j(1 \to 3)$ représente le sous vecteur de $V_j$ comprenant les trois premières composantes de $V_j$, ($j \in \{x;y;z\}$); et

Rot représente la matrice de rotation de l'élément porteur.

Ainsi après réglage, les mesures du système tiennent compte des perturbations magnétiques engendrées par l'élément porteur.

Selon un autre aspect il est également proposé un procédé de mesure de champ magnétique par un capteur principal triaxial de mesure de champ magnétique mobile conjointement avec un élément porteur capable de générer au moins un champ magnétique additionnel perturbant les mesures dudit capteur principal triaxial. Ledit capteur triaxial est adapté pour fournir des mesures orthonormées pour un champ magnétique de référence en l'absence de perturbations magnétiques dues audit élément porteur. On règle ledit capteur triaxial principal à partir d'une détermination du champ magnétique de référence.

Dans un mode de mise en oeuvre, on détermine le ou les champs magnétiques additionnels générés par ledit élément porteur à partir de paramètres comprenant des coefficients représentatifs de la sensibilité magnétique dudit élément porteur, des mesures effectuées par ledit capteur principal triaxial, et des variations temporelles de ces dites mesures.

Dans un mode de mise en oeuvre, ladite détermination du ou des champs magnétiques additionnels générés par ledit élément porteur utilise le système d'équations suivant :

$$\begin{cases} B_{\text{réel}_x} = B_{\text{mesuré}_x} - \left( B_{\text{rémanent}_x} + A \times V_x \right) \\ B_{\text{réel}_y} = B_{\text{mesuré}_y} - \left( B_{\text{rémanent}_y} + A \times V_y \right) \\ B_{\text{réel}_z} = B_{\text{mesuré}_z} - \left( B_{\text{rémanent}_z} + A \times V_z \right) \end{cases}$$

dans lequel:

$B_{\text{réel}_x}$, $B_{\text{réel}_y}$, et $B_{\text{réel}_z}$ représentent les composantes respectives du champ magnétique réel selon les axes du capteur principal;

$B_{\text{mesuré}_x}$, $B_{\text{mesuré}_y}$, et $B_{\text{mesuré}_z}$ représentent les composantes respectives du champ magnétique mesuré par le capteur principal selon ses trois axes;

$B_{\text{rémanent}_x}$, $B_{\text{rémanent}_y}$, et $B_{\text{rémanent}_z}$ représentent les composantes respectives du champ magnétique rémanent selon les axes du capteur principal;

$$A = \left[ B_{\text{mesuré}_x} \, ; \, B_{\text{mesuré}_y} \, ; \, B_{\text{mesuré}_z} \, ; \, \frac{\partial B_{\text{mesuré}_x}}{\partial t} \, ; \, \frac{\partial B_{\text{mesuré}_y}}{\partial t} \, ; \, \frac{\partial B_{\text{mesuré}_z}}{\partial t} \right] ;$$

et

les vecteurs $V_x$, $V_y$ et $V_z$ ont pour composantes les coefficients représentatifs de la sensibilité magnétique dudit élément porteur :

$$V_x = \begin{bmatrix} a_{xx}^i \\ a_{yx}^i \\ a_{zx}^i \\ a_{xx}^f \\ a_{yx}^f \\ a_{zx}^f \end{bmatrix} \qquad V_y = \begin{bmatrix} a_{xy}^i \\ a_{yy}^i \\ a_{zy}^i \\ a_{xy}^f \\ a_{yy}^f \\ a_{zy}^f \end{bmatrix} \qquad V_z = \begin{bmatrix} a_{xz}^i \\ a_{yz}^i \\ a_{zz}^i \\ a_{xz}^f \\ a_{yz}^f \\ a_{zz}^f \end{bmatrix}$$

dont les composantes ou coefficients représentatifs de la sensibilité magnétique dudit élément porteur $a_{jk}^i$ représentent respectivement le coefficient de proportionnalité entre la valeur de la perturbation sur l'axe j due à l'axe k et la valeur du champ sur l'axe k, pour le champ magnétique induit, et les composantes ou coefficients représentatifs de la sensibilité magnétique dudit élément porteur $a_{jk}^f$ représentent respectivement le coefficient de proportionnalité entre la valeur de la perturbation sur l'axe j due à l'axe k et la valeur de la dérivée temporelle du champ sur l'axe k, pour le champ magnétique du aux courants de Foucault.

L'invention sera mieux comprise à l'étude de quelques modes de réalisation décrits à titre d'exemples nullement limitatifs et illustrés par les dessins annexés sur lesquels :

- la figure 1 illustre schématiquement un système avec un capteur additionnel amovible triaxial;
- la figure 2 illustre schématiquement un système avec un capteur additionnel amovible;
- la figure 3 illustre le réglage ou calibrage d'un système de la figure 1 ;
- la figure 4 illustre le réglage ou calibrage d'un système de la figure 2;
- la figure 5 illustre le fonctionnement en régime établi d'un mode de réalisation d'un système de la figure 1 ou 2; et
- la figure 6 illustre le fonctionnement en régime établi d'un mode de réalisation d'un système de la figure 1 ou 2.

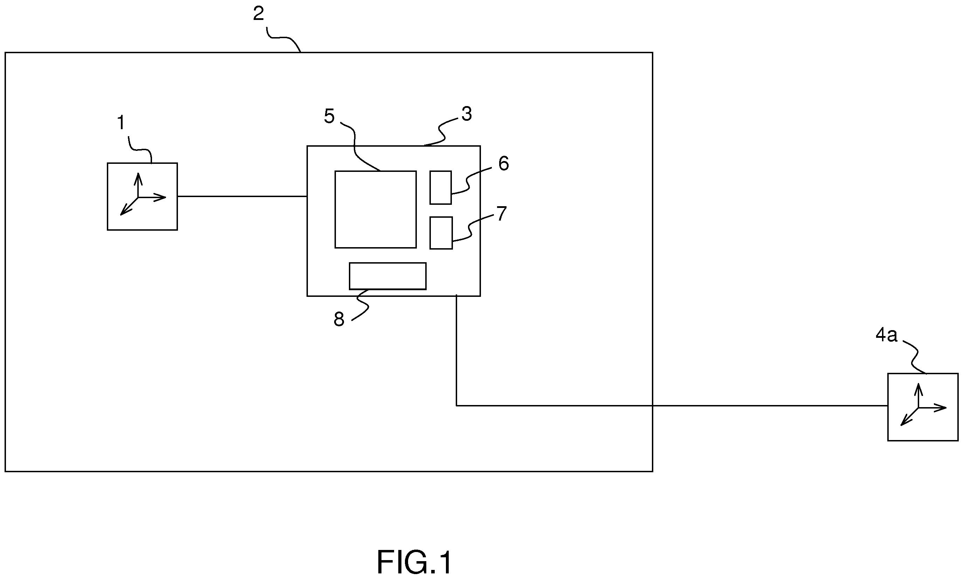

Tel qu'illustré sur la figure1, un système de mesure de champ magnétique selon un aspect de l'invention comprend un capteur principal triaxial 1 de mesure de champ magnétique, mobile conjointement avec un élément porteur 2 capable de générer au moins un champ magnétique additionnel perturbant les mesures du capteur 1. L'élément porteur 2 peut, par exemple, être un boitier de téléphone portable, de télécommande, d'ordinateur portable, ou tout autre élément pouvant comprendre une fonctionnalité de mesure de champ magnétique. Le capteur principal triaxial 1 fournit des mesures orthonormées pour un champ magnétique de référence en l'absence de perturbations magnétiques de l'élément porteur 2. le champ magnétique de référence pour lequel, en l'absence de perturbations magnétiques de l'élément porteur, les mesures fournies par le capteur triaxial principal 1 sont orthonormées, peut, par exemple être le champ magnétique à la surface de la Terre.

Le réglage du capteur principal triaxial 1 est effectué par une unité de commande électronique 3 et un capteur additionnel amovible triaxial 4a, mobile conjointement avec l'élément porteur 2. En d'autres termes, la liaison entre le capteur additionnel amovible 4a et le reste du système est une liaison rigide.

Un module de détermination 5 détermine le ou les champs magnétiques additionnels générés par l'élément porteur 2 à partir de paramètres comprenant des coefficients représentatifs de la sensibilité magnétique de l'élément porteur 2, des mesures effectuées par le capteur principal triaxial 1, et des variations temporelles de ces mesures.

Un premier module de calcul 6 calcule les composantes respectives $B_{rémanent_x}$, $B_{rémanent_y}$, $B_{rémanent_z}$, du champ magnétique rémanent $B_{rémanent}$ par différences entre des moyennes de mesures effectuées simultanément par les deux capteurs triaxiaux 1 et 4a.

Un deuxième module de calcul 7 calcule des vecteurs $V_x$, $V_y$, $V_z$ des coefficients représentatifs de la sensibilité magnétique de l'élément porteur 2 par estimation des moindres carrés sur le système d'équations suivant :

$$\begin{cases} A \times V_x = \left( B_{mesuré_x} - B_{rémanent_x} \right) \\ A \times V_y = \left( B_{mesuré_y} - B_{rémanent_y} \right) \\ A \times V_z = \left( B_{mesuré_z} - B_{rémanent_z} \right) \end{cases}$$

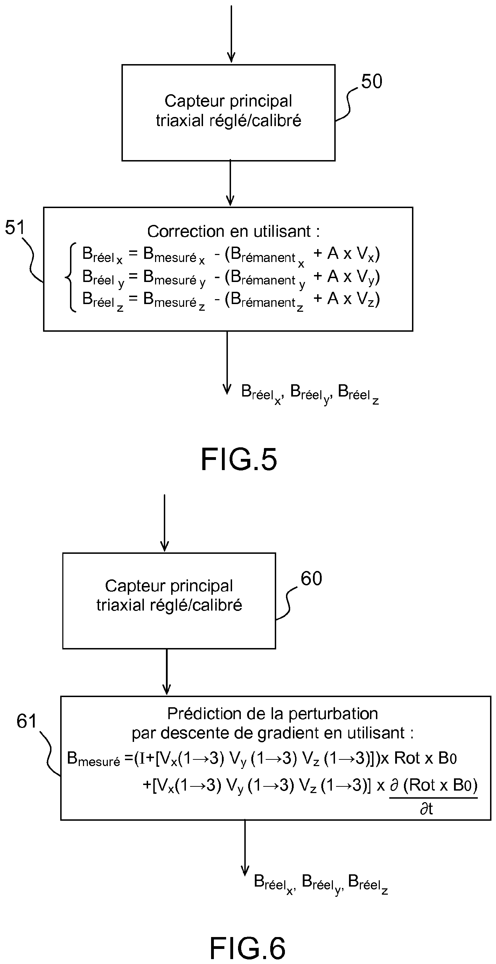

Un module de correction 8 corrige les mesures du capteur principal triaxial 1 pour délivrer le champ magnétique réel $B_{réel}$ à partir du champ magnétique mesuré $B_{mesuré}$ par le capteur principal triaxial 1 et des données fournies par l'unité de commande électronique 3. Des exemples de réalisation du module de correction 8 sont décrits ultérieurement par les figures 5 et 6.

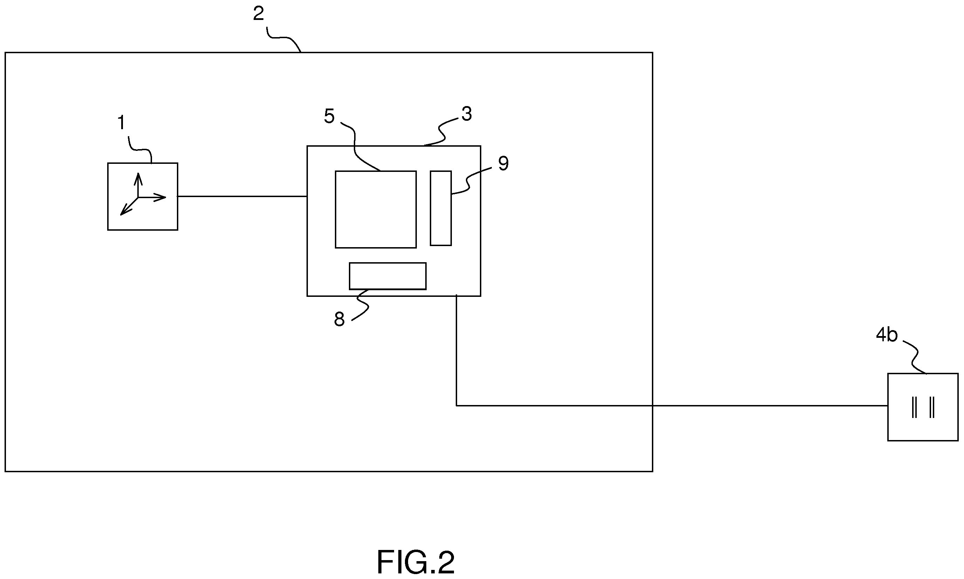

La figure 2 représente un autre mode réalisation dans lequel le capteur additionnel amovible de mesure du champ magnétique est un capteur scalaire 4b, ou, en d'autres termes un capteur fournissant la norme d'un champ magnétique, et non ses composantes selon trois axes comme le capteur triaxial 4a de la figure 1.

Les éléments du système ayant des références identiques à des références de la figure 1 sont des éléments identiques à ceux de la figure 1.

Le mode de réalisation représenté sur la figure 2 ne comprend pas les modules de calcul 6 et 7, mais comprend un module d'optimisation 9 pour optimiser l'égalité suivante pour une série de mesures effectuées simultanément avec le capteur principal triaxial 1 et le capteur additionnel scalaire 4b :

$$\left\| Mes\_scalaire \right\| = \left\| B_{mesuré} - B_{perturbateur} \right\|$$

dans laquelle $\left\| Mes\_scalaire \right\|$ représente une norme d'une mesure du capteur additionnel scalaire 4b, et $B_{perturbateur}$ représente le ou les champs magnétiques additionnels perturbants générés par ledit élément porteur 2.

Le capteur additionnel amovible, qu'il soit triaxial 4a comme dans le système de la figure 1, ou scalaire 4b comme dans le système de la figure 2, est utilisé dans une phase de réglage ou calibration du capteur triaxial principal 1. En phase de fonctionnement établi du système, lorsque le capteur principal triaxial 1 est calibré ou réglé, le capteur additionnel 4a ou 4b amovible a été retiré.

En variante des systèmes des figures 1 et 2, le système peut comprendre, à la place d'un capteur additionnel amovible 4a ou 4b servant au réglage ou calibrage du capteur principal triaxial 1, un générateur de champ magnétique prédéterminé auquel est soumis me système. Ainsi on connaît parfaitement le champ magnétique de référence.

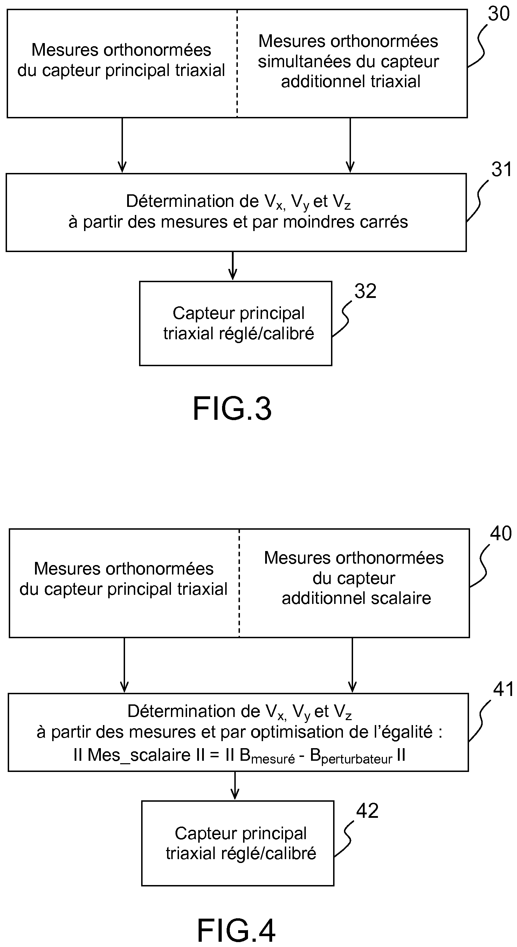

La figure 3 illustre le calibrage du capteur triaxial principal 1 du système de la figure 1. Des mesures sont effectuées simultanément (étape 30) par le capteur triaxial principal 1 et par le capteur triaxial additionnel 4a. A partir de ces mesures (étape 30), les premier et deuxième modules de calcul 6 et 7 déterminent les vecteurs $V_x$, $V_y$, $V_z$ des coefficients représentatifs de la sensibilité magnétique de l'élément porteur 2 (étape 31) de la façon décrite précédemment, par moindres carrés. Ainsi, le capteur principal triaxial 1 est réglé ou calibré (étape 32).

La figure 4 illustre le calibrage du capteur triaxial principal 1 du système de la figure 2. Des mesures sont effectuées simultanément (étape 40) par le capteur triaxial principal 1 et par le capteur scalaire additionnel 4b. A partir de ces mesures (étape 40), le module d'optimisation 9 détermine les vecteurs $V_x$, $V_y$, $V_z$ des coefficients représentatifs de la sensibilité magnétique de l'élément porteur 2 (étape 41) de la façon décrite précédemment, par optimisation d'une égalité. Ainsi, le capteur principal triaxial 1 est réglé ou calibré (étape 42).

Les figures 5 et 6 illustrent le fonctionnement d'un système selon la figure 1 ou 2 ayant été réglé ou calibré (respectivement étapes 50 et 60) comme illustré par les figures 3 ou 4.

Dans le cas de la figure 5, le module de correction 8 corrige (étape 51) les mesures du capteur triaxial principal 1 pour délivrer le champ magnétique réel à partir de ces mesures et de données fournies par les modules de calcul 6 et 7 ou par le module d'optimisation 9, selon le mode de réalisation du système, en utilisant le système d'équations suivant :

$$\begin{cases} B_{réel_x} = B_{mesuré_x} - \left( B_{rémanent_x} + A \times V_x \right) \\ B_{réel_y} = B_{mesuré_y} - \left( B_{rémanent_y} + A \times V_y \right) \\ B_{réel_z} = B_{mesuré_z} - \left( B_{rémanent_z} + A \times V_z \right) \end{cases}$$

Dans le cas de la figure 6, le module de correction 8 corrige (étape 61) les mesures du capteur triaxial principal 1 pour délivrer le champ magnétique réel par correction prédictive par descente de gradient utilisant la relation suivante :

$$B_{mesuré} = (I + [V_x(1 \rightarrow 3) \quad V_y(1 \rightarrow 3) \quad V_z(1 \rightarrow 3)]) * Rot * B_0$$

$$+ [V_x(1 \rightarrow 3) \quad V_y(1 \rightarrow 3) \quad V_z(1 \rightarrow 3)] * \frac{\partial}{\partial t}(Rot * B_0)$$

dans laquelle:

I représente la matrice identité $\begin{pmatrix} 1 & 0 & 0 \\ 0 & 1 & 0 \\ 0 & 0 & 1 \end{pmatrix}$ ;

$B_0$ représente le champ magnétique de référence ;

$V_j(1 \rightarrow 3)$ représente le sous vecteur de $V_j$ comprenant les trois premières composantes de $V_j$, $(j \in \{x;y;z\})$; et

Rot représente la matrice de rotation de l'élément porteur.

La présente invention permet de mesurer, de manière précise et à coût réduit, un champ magnétique au moyen d'un capteur triaxial lié à élément porteur capable de générer au moins un champ magnétique additionnel perturbant les mesures, en annihilant l'effet du ou des champs magnétiques additionnels sur les mesures. L'invention permet d'éliminer l'influence sur les mesures du ou des champs magnétiques perturbateurs.

## Revendications

1. Procédé de mesure de champ magnétique triaxial par un capteur principal triaxial (1) de mesure de champ magnétique mobile conjointement avec un élément porteur (2) capable de générer au moins un champ magnétique additionnel perturbant les mesures dudit capteur principal triaxial (1), ledit capteur triaxial (1) étant adapté pour fournir des mesures orthonormées pour un champ magnétique de référence en l'absence de perturbations magnétiques dues audit élément porteur (2), **caractérisé en ce que** l'on règle ledit capteur principal triaxial (1) par les étapes suivantes de :

   - calibration dudit capteur principal triaxial (1) à partir d'une détermination du champ magnétique de référence, ladite détermination du champ magnétique de référence utilisant un générateur de champ magnétique prédéterminé ou un capteur additionnel (4a, 4b) amovible de mesure de champ magnétique, mobile conjointement avec ledit élément porteur (2), et disposé à l'extérieur dudit élément porteur (2) en dehors du ou des champs magnétiques additionnels ;
   - correction, après calibration, en fonctionnement établi, des mesures dudit capteur principal trixial (1), sans capteur additionnel ou générateur de champ magnétique prédéterminé.

2. Procédé selon la revendication 1, dans lequel on détermine le ou les champs magnétiques additionnels générés par ledit élément porteur (2) à partir de paramètres comprenant des coefficients représentatifs de la sensibilité magnétique dudit élément porteur (2), des mesures effectuées par ledit capteur principal triaxial (1), et des variations temporelles de ces dites mesures.

3. Procédé selon la revendication 2, dans lequel ladite détermination du ou des champs magnétiques additionnels générés par ledit élément porteur (2) utilise le système d'équations suivant :

$$\begin{cases} B_{réel_x} = B_{mesuré_x} - \left(B_{rémanent_x} + A \times V_x\right) \\ B_{réel_y} = B_{mesuré_y} - \left(B_{rémanent_y} + A \times V_y\right) \\ B_{réel_z} = B_{mesuré_z} - \left(B_{rémanent_z} + A \times V_z\right) \end{cases}$$

dans lequel:

$B_{réel_x}$, $B_{réel_y}$, et $B_{réel_z}$ représentent les composantes respectives du champ magnétique réel selon les trois axes du capteur principal triaxial (1) ;
$B_{mesuré_x}$, $B_{mesuré_y}$, et $B_{mesuré_z}$ représentent les composantes respectives du champ magnétique mesuré par le capteur principal triaxial (1) selon ses trois axes;
$B_{rémanent_x}$, $B_{rémanent_y}$, et $B_{rémanent_z}$ représentent les composantes respectives du champ magnétique rémanent selon les trois axes du capteur principal triaxial (1) ;

$$A = \left[ B_{mesuré_x} \,;\, B_{mesuré_y} \,;\, B_{mesuré_z} \,;\, \frac{\partial B_{mesuré_x}}{\partial t} \,;\, \frac{\partial B_{mesuré_y}}{\partial t} \,;\, \frac{\partial B_{mesuré_z}}{\partial t} \right] ;$$

et
les vecteurs $V_x$, $V_y$ et $V_z$ ont pour composantes les coefficients représentatifs de la sensibilité magnétique dudit élément porteur (2) :

$$V_x = \begin{bmatrix} a_{xx}^i \\ a_{yx}^i \\ a_{zx}^i \\ a_{xx}^f \\ a_{yx}^f \\ a_{zx}^f \end{bmatrix} \qquad V_y = \begin{bmatrix} a_{xy}^i \\ a_{yy}^i \\ a_{zy}^i \\ a_{xy}^f \\ a_{yy}^f \\ a_{zy}^f \end{bmatrix} \qquad V_z = \begin{bmatrix} a_{xz}^i \\ a_{yz}^i \\ a_{zz}^i \\ a_{xz}^f \\ a_{yz}^f \\ a_{zz}^f \end{bmatrix}$$

dont les composantes ou coefficients représentatifs de la sensibilité magnétique dudit élément porteur $a_{jk}^i$ représentent respectivement le coefficient de proportionnalité entre la valeur de la perturbation sur l'axe j due à l'axe k et la valeur du champ sur l'axe k, pour le champ magnétique induit, et les composantes ou coefficients représentatifs de la sensibilité magnétique dudit élément porteur $a_{jk}^f$ représentent respectivement le coefficient de proportionnalité entre la valeur de la perturbation sur l'axe j due à l'axe k et la valeur de la dérivée temporelle du champ sur l'axe k, pour le champ magnétique du aux courants de Foucault.

4. Procédé selon l'une des revendications 1 à 3, dans lequel l'étape de correction (8) des mesures dudit capteur principal triaxial (1) délivre le champ magnétique réel à partir du champ magnétique mesuré par ledit capteur principal triaxial (1) et des données fournies par lesdits moyens de réglage en utilisant le système d'équations suivant :

$$\begin{cases} B_{réel_x} = B_{mesuré_x} - \left( B_{rémanent_x} + A \times V_x \right) \\ B_{réel_y} = B_{mesuré_y} - \left( B_{rémanent_y} + A \times V_y \right) \\ B_{réel_z} = B_{mesuré_z} - \left( B_{rémanent_z} + A \times V_z \right) \end{cases}$$

**5.** Procédé selon l'une des revendications 1 à 3, dans lequel l'étape de correction (8) prédictive par prise en compte des perturbations d'un modèle prédictif, par descente de gradient du ou des champs magnétiques additionnels, adaptés pour utiliser la relation suivante :

$$B_{mesuré} = (I + [V_x(1 \to 3) \quad V_y(1 \to 3) \quad V_z(1 \to 3)]) * Rot * B_0$$
$$+ [V_x(1 \to 3) \quad V_y(1 \to 3) \quad V_z(1 \to 3)] * \frac{\partial}{\partial t}(Rot * B_0)$$

dans laquelle:

$$\begin{pmatrix} 1 & 0 & 0 \\ 0 & 1 & 0 \\ 0 & 0 & 1 \end{pmatrix} ;$$

I représente la matrice identité
$B_0$ représente le champ magnétique de référence ;
$V_j(1 \to 3)$ représente le sous vecteur de $V_j$ comprenant les trois premières composantes de $V_j$, ($j \in \{x;y;z\}$); et
Rot représente la matrice de rotation de l'élément porteur.

**Patentansprüche**

**1.** Verfahren zur dreiachsigen Messung eines Magnetfelds durch einen dreiachsigen Hauptsensor (1) zum Messen eines mobilen Magnetfelds zusammen mit einem Trägerelement (2), das fähig ist, mindestens ein zusätzliches Magnetfeld zu generieren, das die Messungen des dreiachsigen Hauptsensors (1) stört, wobei der dreiachsige Sensor (1) angepasst ist, um orthonormierte Messungen für ein Referenzmagnetfeld zu liefern in Abwesenheit von magnetischen Störungen aufgrund des Trägerelements (2), **dadurch gekennzeichnet, dass** der dreiachsige Hauptsensor (1) eingestellt wird durch die folgenden Stufen für:

- eine Kalibrierung des dreiachsigen Hautsensors (1), ausgehend von einer Bestimmung des Referenzmagnetfelds, wobei die Bestimmung des Referenzmagnetfelds einen vorgegebenen Magnetfeldgenerator oder einen zusätzlichen abnehmbaren Sensor (4a, 4b) zum Messen eines Magnetfelds verwendet, der zusammen mit dem Trägerelement (2) beweglich ist und außerhalb des Trägerelements (2) außerhalb des oder der zusätzlichen Magnetfelder angeordnet ist;
- nach der Kalibrierung eine Korrektur, bei laufendem Betrieb, der Messungen des dreiachsigen Hauptsensors (1) ohne zusätzlichen Sensor oder vorgegebenen Magnetfeldgenerator.

**2.** Verfahren nach Anspruch 1, wobei das oder die zusätzlichen Magnetfelder bestimmt werden, die durch das Trägerelement (2) generiert werden, ausgehend von Parametern, die repräsentative Koeffizienten für die magnetische Empfindlichkeit des Trägerelements (2), durch den dreiachsigen Hauptsensor (1) ausgeführte Messungen und temporale Veränderungen dieser Messungen aufweisen.

**3.** Verfahren nach Anspruch 2, wobei die Bestimmung des oder der zusätzlichen Magnetfelder, die durch das Trägerelement (2) generiert werden, das folgende Gleichungssystem verwendet:

$$\begin{cases} B_{real_x} = B_{gemessen_x} - \left( B_{remanent_x} + A \times V_x \right) \\ B_{real_y} = B_{gemessen_y} - \left( B_{remanent_y} + A \times V_y \right) \\ B_{real_z} = B_{gemessen_z} - \left( B_{remanent_z} + A \times V_z \right) \end{cases}$$

wobei:

$B_{real_x}$, $B_{real_y}$ und $B_{real_z}$ die jeweiligen Komponenten des realen Magnetfelds gemäß den drei Achsen des dreiachsigen Hauptsensors (1) darstellen;

$B_{gemessen_x}$, $B_{gemessen_y}$ und $B_{gemessen_z}$ die jeweiligen Komponenten des durch den dreiachsigen Hauptsensor (1) gemäß seinen drei Achsen gemessenen Magnetfelds darstellen;

$B_{remanent_x}$, $B_{remanent_y}$ und $B_{remanent_z}$ die jeweiligen Komponenten des remanenten Magnetfelds gemäß den drei Achsen des dreiachsigen Hauptsensors (1) darstellen;

$$A = \left[ B_{gemessen_x};\ B_{gemessen_y};\ B_{gemessen_z};\ \frac{\partial B_{gemessen_x}}{\partial t};\ \frac{\partial B_{gemessen_y}}{\partial t};\ \frac{\partial B_{gemessen_z}}{\partial t} \right];$$

und

die Vektoren $V_x$, $V_y$ und $V_z$ als Komponenten die Koeffizienten haben, die für die magnetische Empfindlichkeit des Trägerelements (2) repräsentativ sind:

$$V_x = \begin{bmatrix} a_{xx}^i \\ a_{yx}^i \\ a_{zx}^i \\ a_{xx}^f \\ a_{yx}^f \\ a_{zx}^f \end{bmatrix} \qquad V_y = \begin{bmatrix} a_{xy}^i \\ a_{yy}^i \\ a_{zy}^i \\ a_{xy}^f \\ a_{yy}^f \\ a_{zy}^f \end{bmatrix} \qquad V_z = \begin{bmatrix} a_{xz}^i \\ a_{yz}^i \\ a_{zz}^i \\ a_{xz}^f \\ a_{yz}^f \\ a_{zz}^f \end{bmatrix}$$

deren Komponenten oder repräsentative Koeffizienten der magnetischen Empfindlichkeit des Trägerelements $a_{jk}^i$ jeweils den Proportionalitätsfaktor zwischen dem Wert der Störung auf der Achse j aufgrund der Achse k und dem Wert des Felds auf der Achse k für das induzierte Magnetfeld darstellen, und die Komponenten oder repräsentativen Koeffizienten der magnetischen Empfindlichkeit des Trägerelements $a_{jk}^f$ jeweils den Proportionalitätsfaktor zwischen dem Wert der Störung auf der Achse j aufgrund der Achse k und dem Wert der temporalen Abweichung des Felds auf der Achse k für das Magnetfeld aufgrund der Foucaultschen Ströme darstellen.

4. Verfahren nach einem der Ansprüche 1 bis 3, wobei die Korrekturstufe (8) für die Messungen des dreiachsigen Hauptsensors (1) das reale Magnetfeld ausgehend von dem durch den dreiachsigen Hauptsensor (1) gemessenen Magnetfeld und den Daten übergibt, die durch die Einstellungsmittel durch Verwendung des folgenden Gleichungssystems geliefert werden:

$$\begin{cases} B_{real_x} = B_{gemessen_x} - \left( B_{remanent_x} + A \times V_x \right) \\ B_{real_y} = B_{gemessen_y} - \left( B_{remanent_y} + A \times V_y \right). \\ B_{real_z} = B_{gemessen_z} - \left( B_{remanent_z} + A \times V_z \right) \end{cases}$$

5. Verfahren nach einem der Ansprüche 1 bis 3, wobei die prädiktive Korrekturstufe (8) durch Berücksichtigung der Störungen eines prädiktiven Modells, durch Gradientenabfall des oder der zusätzlichen Magnetfelder, angepasst ist zum Verwenden der folgenden Beziehung:

$$\begin{aligned} B_{gemessen} = &\left( I + \left[ V_x(1 \rightarrow 3) \quad V_y(1 \rightarrow 3) \quad V_z(1 \rightarrow 3) \right] \right) * Rot * B_0 \\ &+ \left[ V_x(1 \rightarrow 3) \quad V_y(1 \rightarrow 3) \quad V_z(1 \rightarrow 3) \right] * \frac{\partial}{\partial t} (Rot * B_0) \end{aligned}$$

wobei:

$$\begin{pmatrix} 0 & 1 & 0 \\ 0 & 0 & 1 \end{pmatrix}$$

I die Einheitsmatrix darstellt;

$B_0$ das Referenzmagnetfeld darstellt;

$V_j(1{\to}3)$ den Untervektor $V_j$ darstellt, der die drei ersten Komponenten von $V_j$, ($j \in \{x;y;z\}$) darstellt; und

Rot die Rotationsmatrix des Trägerelements darstellt.

**Claims**

1. A triaxial magnetic field measurement method using a main triaxial sensor (1) for measuring magnetic field that can move together with a carrier element (2) that is able to generate at least one additional magnetic field disrupting the measurements of said main triaxial sensor (1), said triaxial sensor (1) being adapted to provide orthonormal measurements for a reference magnetic field in the absence of magnetic disruption due to said carrier element (2), **characterised in that** said main triaxial sensor (1) is adjusted by means of the following steps:

   - calibrating said main triaxial sensor (1) based on determining the reference magnetic field, said determining of the reference magnetic field using a predetermined magnetic field generator or an additional detachable magnetic field measurement sensor (4a, 4b), which can move together with said carrier element (2) and is disposed outside said carrier element (2) away from the one or more additional magnetic field(s);
   - correcting, after calibration and during steady-state operation, measurements of said main triaxial sensor (1), without an additional sensor or predetermined magnetic field generator.

2. The method according to claim 1, wherein the one or more additional magnetic field(s) generated by said carrier element (2) are determined on the basis of parameters comprising coefficients representing the magnetic sensitivity of said carrier element (2), measurements carried out by said main triaxial sensor (1) and temporal variations of said measurements.

3. The method according to claim 2, wherein said determining of said one or more additional magnetic field(s) generated by said carrier element (2) uses the following system of equations:

$$\begin{cases} B_{real_x} = B_{measured_x} - \left( B_{remanent_x} + A \times V_x \right) \\ B_{real_y} = B_{measured_y} - \left( B_{remanent_y} + A \times V_y \right) \\ B_{real_z} = B_{measured_z} - \left( B_{remanent_z} + A \times V_z \right) \end{cases}$$

in which:

$B_{real_x}$, $B_{real_y}$, and $B_{real_z}$ represent the respective components of the real magnetic field along the three axes of said main triaxial sensor (1);

$B_{measured_x}$, $B_{measured_y}$, and $B_{measured_z}$ represent the respective components of the magnetic field measured by said main triaxial sensor (1) along its three axes;

$B_{remanent_x}$, $B_{remanent_y}$, and $B_{remanent_z}$ represent the respective components of the remanent magnetic field along the three axes of said main triaxial sensor (1);

$$A = \left[ B_{measured_x} ; B_{measured_y} ; B_{measured_z} ; \frac{\partial B_{measured_x}}{\partial t} ; \frac{\partial B_{measured_y}}{\partial t} ; \frac{\partial B_{measured_z}}{\partial t} \right] ;$$

and

the vectors $V_x$, $V_y$ and $V_z$ have the coefficients that represent the magnetic sensitivity of said carrier element (2) as components, namely:

$$V_x = \begin{bmatrix} a_{xx}^{i} \\ a_{yx}^{i} \\ a_{zx}^{i} \\ a_{xx}^{f} \\ a_{yx}^{f} \\ a_{zx}^{f} \end{bmatrix} \quad V_y = \begin{bmatrix} a_{xy}^{i} \\ a_{yy}^{i} \\ a_{zy}^{i} \\ a_{xy}^{f} \\ a_{yy}^{f} \\ a_{zy}^{f} \end{bmatrix} \quad V_z = \begin{bmatrix} a_{xz}^{i} \\ a_{yz}^{i} \\ a_{zz}^{i} \\ a_{xz}^{f} \\ a_{yz}^{f} \\ a_{zz}^{f} \end{bmatrix}$$

the components or coefficients of which that represent the magnetic sensitivity of said carrier element $a_{jk}^{i}$ respectively represent the coefficient of proportionality between the value of the disruption on the axis j due to the axis k and the value of the field on the axis k, for the induced magnetic field, and the components or coefficients that represent the magnetic sensitivity of said carrier element $a_{jk}^{f}$ respectively represent the coefficient of proportionality between the value of the disruption on the axis j due to the axis k and the value of the temporal drift of the field on the axis k for the magnetic field due to the eddy currents.

**4.** The method according to any one of claims 1 to 3, wherein the step (8) of correcting measurements of said main triaxial sensor (1) delivers the real magnetic field on the basis of the magnetic field measured by said main triaxial sensor (1) and the data provided by said adjustment means by using the following system of equations:

$$\begin{cases} B_{real_x} = B_{measured_x} - \left( B_{remanent_x} + A \times V_x \right) \\ B_{real_y} = B_{measured_y} - \left( B_{remanent_y} + A \times V_y \right) \\ B_{real_z} = B_{measured_z} - \left( B_{remanent_z} + A \times V_z \right) \end{cases}$$

**5.** The method according to any one of claims 1 to 3, wherein the step (8) of predictive correction by taking into account any disruption of a predictive model, by gradient descent of the one or more additional magnetic field(s), is adapted to use the following relation:

$$B_{measured} = (I + [V_x(1 \to 3) \quad V_y(1 \to 3) \quad V_z(1 \to 3)]) * Rot * B_0$$
$$+ [V_x(1 \to 3) \quad V_y(1 \to 3) \quad V_z(1 \to 3)] * \frac{\partial}{\partial t}(Rot * B_0)$$

in which:

$$\begin{pmatrix} 1 & 0 & 0 \\ 0 & 1 & 0 \\ 0 & 0 & 1 \end{pmatrix};$$

I represents the identity matrix
$B_0$ represents the reference magnetic field;
$V_j(1 \to 3)$ represents the sub-vector of $V_j$ comprising the first three components of $V_j$, ($j \in \{x;y;z\}$); and
Rot represents the rotation matrix of the carrier element.

FIG.1

EP 2 277 057 B1

FIG.2

| | | 30 |
|---|---|---|
| Mesures orthonormées du capteur principal triaxial | Mesures orthonormées simultanées du capteur additionnel triaxial | |

| | 31 |
|---|---|
| Détermination de $V_x$, $V_y$ et $V_z$ à partir des mesures et par moindres carrés | |

| | 32 |
|---|---|
| Capteur principal triaxial réglé/calibré | |

## FIG.3

| | | 40 |
|---|---|---|
| Mesures orthonormées du capteur principal triaxial | Mesures orthonormées du capteur additionnel scalaire | |

| | 41 |
|---|---|
| Détermination de $V_x$, $V_y$ et $V_z$ à partir des mesures et par optimisation de l'égalité : $\| Mes\_scalaire \| = \| B_{mesuré} - B_{perturbateur} \|$ | |

| | 42 |
|---|---|
| Capteur principal triaxial réglé/calibré | |

## FIG.4

Capteur principal
triaxial réglé/calibré

50

51

Correction en utilisant :

$B_{réel_x} = B_{mesuré_x} - (B_{rémanent_x} + A \times V_x)$

$B_{réel_y} = B_{mesuré_y} - (B_{rémanent_y} + A \times V_y)$

$B_{réel_z} = B_{mesuré_z} - (B_{rémanent_z} + A \times V_z)$

$B_{réel_x}, B_{réel_y}, B_{réel_z}$

# FIG.5

Capteur principal
triaxial réglé/calibré

60

61

Prédiction de la perturbation
par descente de gradient en utilisant :

$B_{mesuré} = (I + [V_x(1\rightarrow3) \ V_y(1\rightarrow3) \ V_z(1\rightarrow3)]) \times Rot \times B_0$

$+ [V_x(1\rightarrow3) \ V_y(1\rightarrow3) \ V_z(1\rightarrow3)] \times \dfrac{\partial (Rot \times B_0)}{\partial t}$

$B_{réel_x}, B_{réel_y}, B_{réel_z}$

# FIG.6

**EP 2 277 057 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5182514 A
- WO 0246693 A